# EUROPÄISCHE PATENTANMELDUNG

(11) **EP 3 985 310 A1**
(43) Veröffentlichungstag der Anmeldung: **20.04.2022**
(21) Anmeldenummer: 21195851.7
(22) Anmeldetag: 09.09.2021
(51) Int. Cl.: F24C 7/08, F24C 15/00

(54) **GARGERÄT MIT KAMERA ZUR ÜBERWACHUNG DES GARRAUMS**

(30) Priorität: 19.10.2020 CH 13432020
(71) Anmelder: V-Zug AG, 6300 Zug (CH)
(72) Erfinder: Herlitzius, Clemens, 8834 Schindellegi (CH); Bosshard, Pascal, 8008 Zürich (CH); Sterba, Thomas, 5643 Sins (CH); Schönenberger, Marc, 8050 Zürich (CH)
(74) Vertreter: E. Blum & Co. AG

(57) **Zusammenfassung**

Ein Gargerät umfasst einen Garraum (2), eine bildgebende Kamera (5) zur Überwachung des Garraums (2), eine Steuerelektronik (7) zur Steuerung des Gargeräts und einen Kühlluftkanal (8) zur Beförderung von Kühlluft. Der Kühlluftkanal (8) ist derart angeordnet und ausgestaltet, dass die Kühlluft von der Kamera (5) zur Steuerelektronik (7) strömt.

## Beschreibung

### Gebiet der Erfindung

Die Erfindung betrifft ein Gargerät mit einem Garraum, einer bildgebenden Kamera zur Überwachung des Garraums, einer Steuerelektronik zur Steuerung des Gargeräts, und einem Kühlluftkanal zur Förderung von Kühlluft.

### Hintergrund

Es ist bekannt, in Gargeräten, insbesondere Backöfen, bildgebende Kameras zu verwenden. Kameras zeichnen das Geschehen innerhalb des Garraums auf. Die Bilddaten können an eine externe Anzeige, beispielsweise an ein Smartphone, übermittelt werden, sodass ausgehend von einem beliebigen Ort mittels der Bildübertragung in den Garraum Einblick genommen werden kann.

Die Bilddaten können auch zur Regelung des Garprozesses verwendet werden. Beispielsweise unterstützen Bilddaten bei der automatischen Berechnung des Gargutvolumens oder auch bei der Verfolgung der Bräunung des Gargutes.

### Darstellung der Erfindung

Es stellt sich die Aufgabe, ein Gargerät mit einer Kamera bereitzustellen, bei welchem die Kamera technisch vorteilhaft in die Gesamtarchitektur des Gargeräts eingeordnet ist.

Diese Aufgabe wird durch den Gegenstand des unabhängigen Anspruchs gelöst. Demgemäss umfasst ein Gargerät einen Garraum, eine bildgebende Kamera zur Überwachung des Garraums, eine Steuerelektronik zur Steuerung des Gargeräts und einen Kühlluftkanal zur Beförderung von Kühlluft. Ein Kühlluftkanal kann in unterschiedliche Abschnitte aufgeteilt sein und auch durch zu kühlende Komponenten unterbrochen werden.

Der Kühlluftkanal ist derart angeordnet und ausgestaltet, dass die Kühlluft von der Kamera zur Steuerelektronik strömt. Mit anderen Worten ist die Steuerelektronik stromabwärts der Kamera angeordnet, d.h. die Kühlluft kühlt zuerst die Kamera und erst anschliessend die Steuerelektronik des Gargeräts.

Unter Kühlluft ist eine Luft zu verstehen, welche die Betriebstemperatur von Kamera und Steuerelektronik kühlen oder kühl halten soll. Die Kühlluft braucht aber nicht aktiv gekühlt worden sein. Es genügt beispielsweise auch Luft mit Raumtemperatur oder Luft welche wärmer als Raumtemperatur ist.

Die Steuerelektronik des Gargeräts ist insbesondere die zentrale Steuerelektronik, welche unterschiedliche Aktoren, insbesondere Heizelemente, Licht und/oder Garraumlüfter ansteuert, Anzeigedaten aufbereitet und/oder auch Signale vom Benutzer und/oder Sensoren empfängt.

Die Kühlung der Kamera und der Steuerelektronik mit derselben Kühlluft hat den Vorteil, dass das Kühlsystem im Gargerät möglichst platzsparend ausgestaltet werden kann. Eine Kühlung dieser beiden Komponenten mit derselben Kühlluft ist möglich, weil die Kamera auf ca. 50°C bis 60°C und die Steuerelektronik lediglich auf 70°C bis 80°C gekühlt werden müssen. D.h. die bereits von der Kamera aufgewärmte Kühlluft ist immer noch ausreichend kühl, um die Steuerelektronik zu kühlen.

Insbesondere ist das Gargerät ein Backofen, eine Mikrowelle, ein Dampfgargerät oder ein Kombigargerät. Ein Kombigargerät kombiniert die Funktionen von mindestens zwei der genannten Gargeräte.

In einer besonderen Ausführungsform ist bei bestimmungsgemässer Positionierung des Gargeräts, beispielsweise auf einem Tisch oder in einer Küchenzeile, die Kamera zumindest teilweise, insbesondere vollständig, oberhalb des Garraums angeordnet, und/oder zumindest teilweise, insbesondere vollständig vor dem Garraum angeordnet, und/oder direkt oberhalb und/oder direkt seitlich des vorderen Drittels des Garraums angeordnet.

"Bei bestimmungsgemässer Positionierung des Gargeräts" bedeutet, dass das Gargerät vertikal und horizontal so montiert ist, wie es vom Hersteller vorgesehen ist. Das bedeutet, dass beispielsweise der auf einem Display angezeigte Text bei normaler Bedienung lesbar ist, sich die Garraumtüre zur Vorderseite und nach unten aufklappen lässt, und/oder beispielsweise bei freistehenden Gargeräten die Stehfüsse auf dem Boden stehen.

Ist die Kamera zumindest teilweise "oberhalb" des Garraums angeordnet, so bedeutet dies, dass zumindest ein Teil der Kamera in vertikaler Richtung weiter oben als die Decke des Garraums angeordnet sein muss. Die Kamera muss aber nicht direkt oberhalb der Garraumdecke angeordnet sein, sondern kann auch seitwärts über den Garraum überlappen. D.h. bei "oberhalb" handelt es sich nur um eine Definition einer vertikalen und nicht auch einer seitlichen Ausrichtung.

Analoges gilt für eine Kamera, welche zumindest teilweise "vor" dem Garraum angeordnet ist. Es handelt sich lediglich um eine Angabe in horizontaler Richtung. Somit kann eine Kamera gleichzeitig zumindest teilweise oberhalb und vor dem Garraum angeordnet sein. Damit die Kamera in diesem Fall in den Garraum Einblick nehmen kann, dürfte sie an der oberen vorderen Kante des Garraums angeordnet sein.

Ist die Kamera beispielsweise "direkt oberhalb" des Garraums angeordnet, so beschränkt dies nicht nur die Positionierung in vertikaler, sondern auch in horizontaler Richtung. In diesem Fall, d.h. bei einer Anordnung "direkt oberhalb" ist die Kamera zumindest teilweise hinter der vorderen Oberkante des Garraums angeordnet.

Die Positionierung der Kamera im vorderen Bereich des Gargeräts hat den Vorteil, dass nur der Garraum selbst eingesehen werden kann. Es ist beispielsweise nicht möglich, durch das Fenster der Türe des Garraums in den Raum der Küche Einblick nehmen zu können. Ein guter Datenschutz ist also gewährleistet. Dies ist natürlich nicht der Fall, wenn die Kamera an der Türe selbst angeordnet ist und sich beim Öffnen der Türe mitbewegt.

Ist die Kamera oben und relativ weit vorne am Garraum angeordnet, ergibt sich ein sehr guter Überblick über den Garraum. D.h. die dreidimensionale Form der im Garraum angeordneten Gargüter kann durch die Kamera sehr gut erfasst werden.

Insbesondere weist der Garraum eine Quaderform auf und insbesondere ist die Kamera an einer oberen, vorderen Ecke des quaderförmigen Garraums angeordnet.

Die Anordnung der Kamera in der Nähe einer Kante des Garraums hat zudem den Vorteil, dass sie möglichst wenig Wärme vom Garraum absorbiert, weil die Kontaktflächen zum Garraum möglichst klein gehalten werden. Zudem ist auch die Gefahr, dass die Kamera von spritzenden Gargütern innerhalb des Garraums verschmutzt wird, verhältnismässig klein. Noch geringer ist die Gefahr, wenn die Kamera in einer Ecke des Garraums angeordnet ist.

Mit Vorteil ist der Kühlluftkanal derart ausgestaltet, dass er zwischen Kamera und Steuerelektronik keine Umlenkungen aufweist. Dadurch kann die Kühlluft möglichst effizient innerhalb des Gargeräts geführt werden und auch die Anordnung der zu kühlenden Komponenten kann möglichst einfach gehalten werden.

Insbesondere umfasst das Gargerät nur genau eine bildgebende Kamera. Mit einer einzigen Kamera kann das Innere des Garraums bereits sehr gut erfasst werden, sodass der Einbau weiterer Kameras, die Kosten verursachen und ebenfalls gekühlt werden müssten, nicht erforderlich ist.

Vorteilhaft ist ein Lüfter zur Förderung der Kühlluft nach der Kamera, d.h. im Kühlluftkanal stromabwärts, angeordnet. Diese Massnahme erlaubt ebenfalls eine kompakte Ausgestaltung der Kühlvorrichtungen.

In einer bevorzugten Ausführungsform ist der Kühlluftkanal in einem Abschnitt unmittelbar vor der Kamera, d.h. stromaufwärts der Kamera, und in einem Abschnitt zwischen Kamera und Steuerelektronik in die gleiche Richtung ausgerichtet. D.h. unmittelbar vor der Kamera und zwischen der Kamera und der Steuerelektronik strömt die Kühlluft in die gleiche Richtung. Dadurch kann die Anzahl Umlenkungen im Kühlluftkanal möglichst gering gehalten werden und es entsteht nicht ein unnötig hoher Strömungswiderstand im Kühlsystem.

Insbesondere ist der Kühlluftkanal unmittelbar nach der Steuerelektronik in die gleiche Richtung ausgerichtet wie der Kühlluftkanal vor der Steuerelektronik.

Vorteilhaft weist das Gargerät eine Ansaugöffnung auf, um bei eingebautem Gargerät die Kühlluft aus einem Spalt zwischen Gargerät und Einbaunische anzusaugen. Die Ansaugöffnung ist seitlich des Garraums und gleich hoch angeordnet wie die Kamera. Damit strömt die Kühlluft aus dem Spalt zwischen Gargerät und Einbaunische auf kürzestem Weg zur Kamera.

In einer besonderen Ausführungsform sind die Ansaugöffnung, die Kamera und die Steuerelektronik in einer geraden Linie angeordnet. Damit braucht die Kühlluft nur über einen möglichst kurzen Weg zwischen den einzelnen Komponenten, d.h. zumindest zwischen Ansaugöffnung, Kamera und Steuerelektronik, zu strömen.

Insbesondere ist die Ansaugöffnung maximal 15 cm, insbesondere maximal 10 cm, insbesondere maximal 5 cm, stromaufwärts der Kamera angeordnet. D.h. die Kühlluft strömt innerhalb des Gargeräts nur über einen sehr kurzen Weg bevor sie die zu kühlende Komponente erreicht.

Vorteilhaft ist die Kamera zwischen linker und rechter Seitenwand mittig angeordnet. Damit blickt die Kamera von oben mittig in den Garraum hinein.

Insbesondere ist Steuerelektronik oberhalb oder hinter der Kamera angeordnet.

Mit Vorteil ist der Kühlluftkanal derart angeordnet und ausgestaltet, dass die Kühlluft zwischen Kamera und Steuerelektronik keine weiteren zu kühlenden Komponenten kühlt.

### Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:
Fig. 1 ein Gargerät mit einer Kamera;
Fig. 2a das Gargerät von Fig. 1 in einer Schnittansicht von vorne;
Fig. 2b das Gargerät von Fig. 1 in einer Schnittansicht von oben;
Fig. 2c das Gargerät von Fig. 1 in einer Schnittansicht von links;
Fig. 3a ein Gargerät mit einer alternativen Anordnung der Kamera in einer Schnittansicht von vorne; und
Fig. 3b das Gargerät von Fig. 3a in einer Schnittansicht von links.

### Wege zur Ausführung der Erfindung

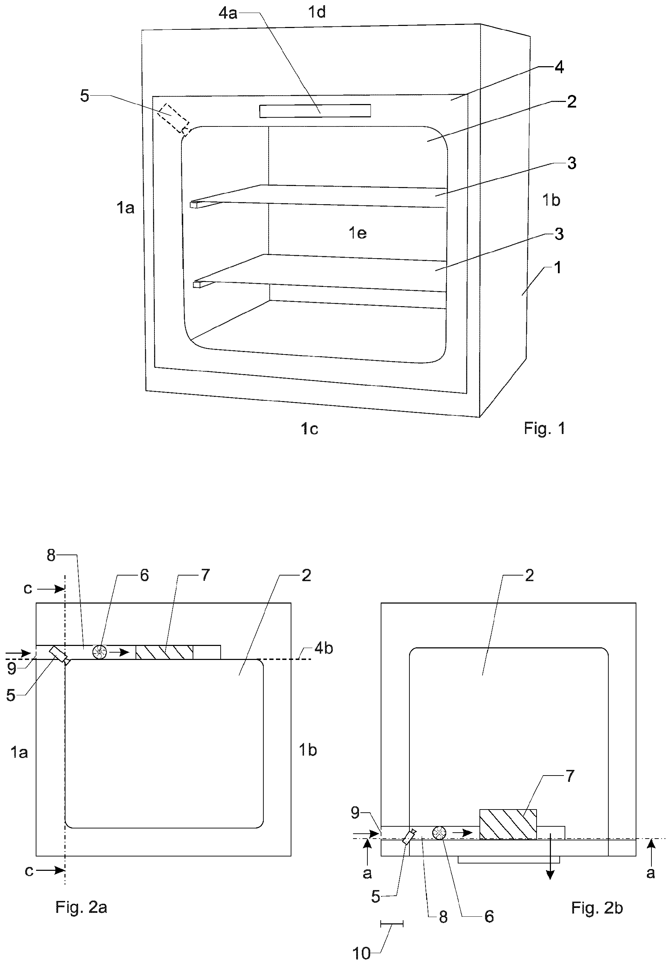

Fig. 1 zeigt ein Haushalts-Gargerät mit Sicht von aussen auf die Frontseite. Das Gargerät umfasst ein Gehäuse 1 und ein im Gehäuse 1 angeordneter Garraum 2. Im Garraum 2 sind eine oder mehrere Gargutauflagen 3 angeordnet. Die Gargutauflagen 3 können z.B. als Gitter, Bleche oder dergleichen ausgestaltet sein. Der Garraum 2 ist, wie für Haushalts-Gargeräte meist üblich, auf fünf Seiten geschlossen und zur Benutzerseite hin über eine Türe 4 zugänglich. Die Türe 4 umfasst einen Türgriff 4a mit welchem die Türe 4 von Hand geöffnet werden kann. Der Garraum 2 erstreckt sich in der Tiefe von der Rückseite des Garraums 2 bis zur Innenseite der Türe 4.

Das Gargerät ist so abgebildet, wie es bei üblichem Gebrauch ausgerichtet ist. D.h. die Bezugsziffer 1a ist links, die Bezugsziffer 1b ist rechts, die Bezugsziffer 1c ist unten und die Bezugsziffer 1d ist oben am Gargerät gezeigt. Mit der Bezugsziffer 1e ist die Rückseite des Garraums markiert. An der Frontseite des Geräts ist die Türe 4 angeordnet.

Das Gargerät umfasst eine bildgebende Kamera 5 zur Überwachung des Garraums. Sie ist lediglich schematisch mit gestrichelten Linien eingezeichnet, da sie von aussen nicht sichtbar ist. Die Kamera 5 ist im quaderförmigen Garraum 2 an der vorderen, linken, oberen Ecke angeordnet.

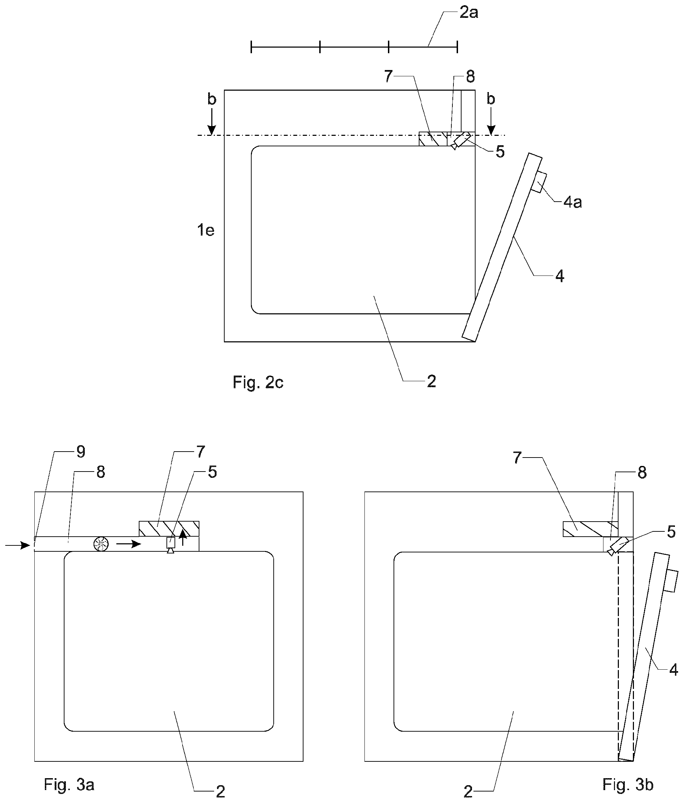

Die Fig. 2a bis 2c zeigen Schnittansichten. Die Schnittansicht der Fig. 2a erfolgt mit Sicht von vorne. Die Schnittlinie ist mit a-a in Fig. 2b gekennzeichnet. Die Schnittansicht der Fig. 2b erfolgt mit Sicht von oben. Die Schnittlinie ist mit b-b in Fig. 2c gekennzeichnet. Die Schnittansicht der Fig. 2c erfolgt mit Sicht von links. Die Schnittlinie ist mit c-c in Fig. 2a eingezeichnet. Die Fig. 2a bis 2c sind schematisch gehalten und zeigen lediglich den Garraum 2, die Kamera 5, einen Lüfter 6, eine Steuerelektronik 7, einen Kühlluftkanal 8 und eine Ansaugöffnung 9.

In der Fig. 2a ist sichtbar, dass die Kamera 5 teilweise oberhalb des Garraums 2 angeordnet ist, d.h. oberhalb der gestrichelten Linie 4b. In nächster Nähe zur Kamera 5 umfasst das Gargerät eine Ansaugöffnung 9 im Gehäuse 1. Dadurch kann kühle Luft, z.B. mit Raumtemperatur, von ausserhalb des Gargeräts in Pfeilrichtung in das Gargerät hineinströmen. Ist das Gargerät in einer Einbaunische montiert, strömt die Kühlluft aus einem Spalt zwischen Gargerät und Nische in das Gargerät hinein.

Direkt nach Eintritt in das Gargerät durch die Ansaugöffnung 9 gelangt die Kühlluft zur Kamera 5 um diese zu kühlen. Durch die Kühlung soll sichergestellt werden, dass die Kamera 5 unterhalb einer Temperatur zwischen 50°C bis 60°C bleibt. Stromabwärts der Kamera 5 strömt die Kühlluft zur Steuerelektronik 7, kühlt die Steuerelektronik 7 auf Temperaturen von maximal 70°C bis 80°C und verlässt anschliessend das Gargerät nach vorne.

Der Kühlluftkanal 8 erstreckt sich von der Ansaugöffnung 9 bis zur Steuerelektronik 7 auf einer geraden Linie, d.h. die Kühlluft strömt im Kühlluftkanalabschnitt zwischen Ansaugöffnung 9 und Kamera 5 in die gleiche Richtung wie im Kühlluftkanalabschnitt zwischen Kamera 5 und Steuerelektronik 7. Diese Ausgestaltung und Anordnung von Kühlluftkanal 8, Ansaugöffnung 9, Kamera 5 und Steuerelektronik 7 erlaubt eine kompakte und einfache Kühlung. Die gerade Erstreckung des Kühlluftkanals 8 betrifft lediglich die Zuführung und Abführung der Kühlluft zur Kamera 5 und Steuerelektronik 7. Selbstverständlich ist es möglich, dass die Kühlluft innerhalb der Kamera 5 oder innerhalb der Steuerelektronik 7 zur Kühlung dieser Komponenten umgelenkt wird.

Zu erwähnen ist, dass der Lüfter 6, welcher die Kühlluft innerhalb des Kühlluftkanals 8 befördert, zwischen der Kamera 5 und der Steuerelektronik 7 angeordnet ist.

Die Fig. 2b zeigt das Gargerät von oben. Auch hier ist sichtbar wie die Kühlluft von links durch die Ansaugöffnung 9 in das Gargerät hineinströmt. Die Kamera 5 und die Steuerelektronik 7 werden auf direkter Linie gekühlt, da der Kühlluftkanal von der Ansaugöffnung 9 bis zur Steuerelektronik 7 keine Umlenkungen aufweist. Im Anschluss an die Steuerelektronik 7 wird die Kühlluft umgelenkt und die Kühlluft verlässt das Gargerät zur Vorderseite des Geräts.

Um die Distanzen kurz zu halten, ist die Ansaugöffnung 9 sehr nahe zur Kamera 5 angeordnet. Der Abstand zwischen der Kamera 5 und der Ansaugöffnung 9 ist mit der Abstandsmarke 10 gekennzeichnet. Dieser Abstand ist etwa 5 cm lang, d.h. die Ansaugöffnung 9 ist ca. 5 cm stromaufwärts zur Kamera 5 angeordnet.

Die Fig. 2c zeigt das Gargerät mit Sicht von links. Es ist sichtbar, wie die Kamera 5 weit vorne zumindest teilweise oberhalb des Garraums 2 angeordnet ist. Sie befindet sich zumindest teilweise direkt oberhalb des vordersten Drittels 2a des Garraums 2.

In den Fig. 3a und 3b ist eine zweite Ausführungsform dargestellt. Hier ist die Kamera 5 an der oberen Vorderkante des Garraums 2 in der Mitte angeordnet. Wie in Fig. 3b sichtbar, ist die Kamera 5 zumindest teilweise vor dem Garraum, d.h. teilweise zwischen Garraum und Frontseite, angeordnet.

Illustriert wird die zweite Ausführungsform mit einer Ansicht von vorne in Fig. 3a und einer Ansicht von links in Fig. 3b. Bei dieser Ausführungsform ist die Steuerelektronik 7 oberhalb der Kamera 5 angeordnet. Die Kühlluft strömt durch die Ansaugöffnung 9 in das Gargerät hinein, gelangt zur Kamera 5, wird anschliessend um 90° nach oben umgelenkt und gelangt sodann zur Steuerelektronik 7.

Während in der vorliegenden Anmeldung bevorzugte Ausführungen der Erfindung beschrieben sind, ist klar darauf hinzuweisen, dass die Erfindung nicht auf diese beschränkt ist und in auch anderer Weise innerhalb des Umfangs der folgenden Ansprüche ausgeführt werden kann.

## Patentansprüche

1. Gargerät, umfassend
- einen Garraum (2),
- eine bildgebende Kamera (5) zur Überwachung des Garraums (2),
- eine Steuerelektronik (7) zur Steuerung des Gargeräts,
- einen Kühlluftkanal (8) zur Beförderung von Kühlluft,
**dadurch gekennzeichnet, dass** der Kühlluftkanal (8) derart angeordnet und ausgestaltet ist, dass die Kühlluft von der Kamera (5) zur Steuerelektronik (7) strömt.

2. Gargerät nach Anspruch 1, wobei bei bestimmungsgemässer Positionierung des Gargeräts die Kamera (5),
- zumindest teilweise, insbesondere vollständig, oberhalb des Garraums (2) angeordnet ist, und/oder zumindest teilweise, insbesondere vollständig vor dem Garraum (2) angeordnet ist, oder
- zumindest teilweise direkt oberhalb und/oder direkt seitlich des vorderen Drittels des Garraums (2) angeordnet ist.

3. Gargerät nach einem der vorangehenden Ansprüche, wobei der Kühlluftkanal (8) derart ausgestaltet ist, dass er zwischen Kamera (5) und Steuerelektronik (7) keine Umlenkungen aufweist.

4. Gargerät nach einem der vorangehenden Ansprüche, wobei das Gargerät nur genau eine der Kamera (5) umfasst.

5. Gargerät nach einem der vorangehenden Ansprüche, aufweisend einen Lüfter (6) zur Förderung der Kühlluft, wobei der Lüfter (6) stromabwärts der Kamera (5) angeordnet ist.

6. Gargerät nach einem der vorangehenden Ansprüche, wobei der Kühlluftkanal (8) in einem Abschnitt unmittelbar vor der Kamera (5) und in einem Abschnitt zwischen Kamera (5) und Steuerelektronik (7) in die gleiche Richtung ausgerichtet ist,
insbesondere wobei der Kühlluftkanal (8) unmittelbar nach der Steuerelektronik (7) in die gleiche Richtung ausgerichtet ist.

7. Gargerät nach einem der vorangehenden Ansprüche, wobei das Gargerät eine Ansaugöffnung (9) aufweist, um bei eingebautem Gargerät die Kühlluft aus einem Spalt zwischen Gargerät und Einbaunische anzusaugen.

8. Gargerät nach Anspruch 7, wobei die Ansaugöffnung (9)
- seitlich des Garraums (2) angeordnet ist, und
- gleich hoch angeordnet ist wie die Kamera (5) .

9. Gargerät nach Anspruch 7 oder 8, wobei die Ansaugöffnung (9), die Kamera (5) und die Steuerelektronik (7) in einer geraden Linie angeordnet sind.

10. Gargerät nach einem der Ansprüche 7 bis 9, wobei die Ansaugöffnung (9) maximal 15 cm, insbesondere maximal 10 cm, insbesondere maximal 5 cm, in Strömungsrichtung vor der Kamera (5) angeordnet ist.

11. Gargerät nach einem der Ansprüche 1 bis 8, wobei die Kamera (5) zwischen linker und rechter Seitenwand des Garraums (2) mittig angeordnet ist.

12. Gargerät nach einem der Ansprüche 1 bis 8 oder 9, wobei die Steuerelektronik (7) oberhalb oder hinter der Kamera (5) angeordnet ist.

13. Gargerät nach einem der vorangehenden Ansprüche, wobei der Kühlluftkanal (8) derart angeordnet und ausgestaltet ist, dass die Kühlluft zwischen Kamera (5) und Steuerelektronik (7) keine weiteren zu kühlenden Komponenten kühlt.
